# EUROPEAN PATENT APPLICATION

(11) **EP 0 708 584 A1**
(43) Date of publication of application: **24.04.1996**
(21) Application number: 95307367.3
(22) Date of filing: 17.10.1995
(51) Int. Cl.: H05K 7/10, G01R 1/04

(54) **Socket for electrical device**

(30) Priority: 18.10.1994 JP 252071/94
(71) Applicant: THOMAS & BETTS CORPORATION, Memphis Tennessee 38119 (US)
(72) Inventor: Koiso, Masakazu, Tama-City, Tokyo (JP)
(74) Representative: Howick, Nicholas Keith

(57) **Abstract**

The present invention improves operability in storing an electronic device in a storing portion, facilitates heat dissipation from the stored electronic device, and prevents deformation of the contact of the contact element. A constricted portion (13) is provided in a socket member (10), so that an electronic device can be stored and will not collide with the socket member in a storing portion, thereby improving the operational efficiency. A window (21) is formed in a cover (20) so as to entirely expose the top surface of the stored electronic device. A gap is provided between the bottom of the electronic device and the bottom of the socket member, so that heat can be easily dissipated from the electronic device. The contacts of the spring contacts are formed into arcuate shapes, so that the contacts will not be easily deformed.

## Description

### Field of the Invention

The present invention relates to a socket for storing an electronic device, e.g., an IC or a packaged composite device and, more particularly, to a socket having a cover that can be freely capped/uncapped.

### Background of the Invention

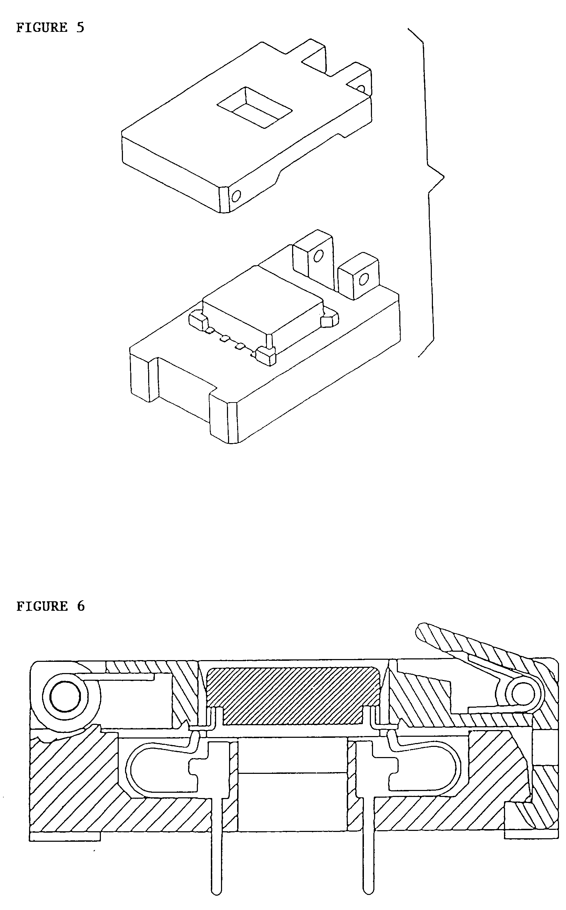

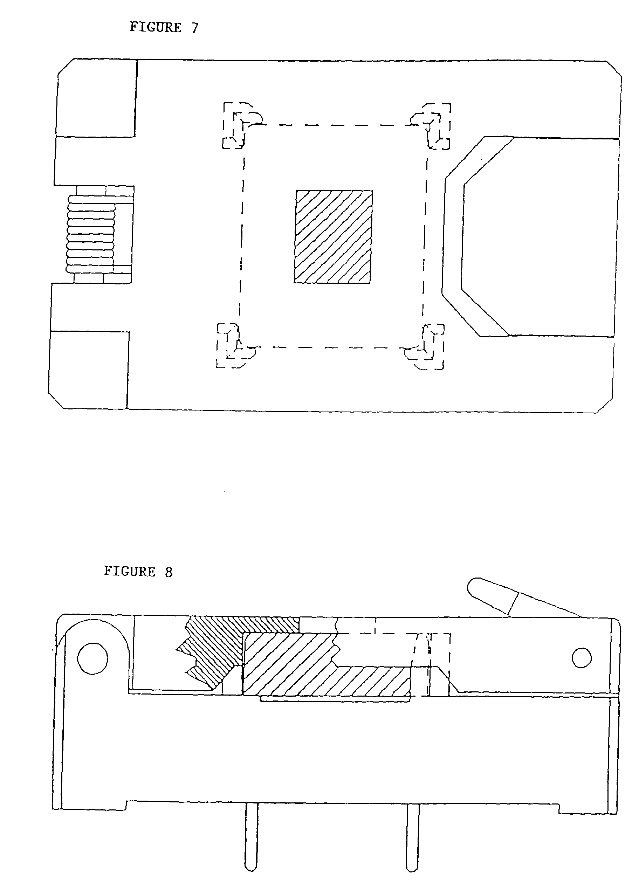

Figures 5 to 8 show a conventional socket of this type.

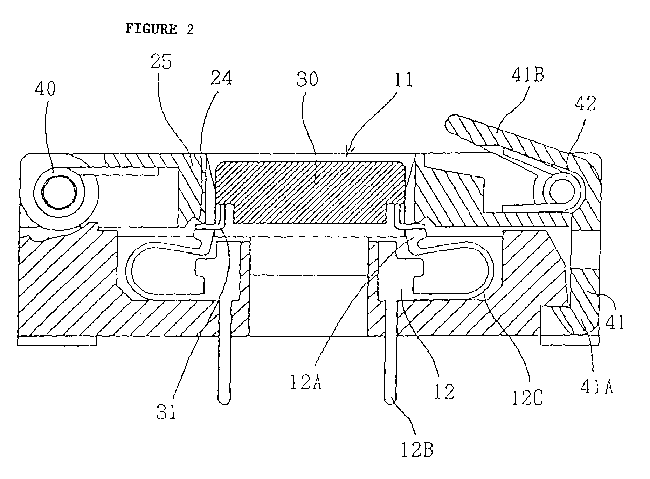

As is seen from Figures 5 to 8, in the conventional socket, an electronic device stored in the socket member is capped by a cover. The entire portion of the lower half of the electronic device is stored in a storing groove formed in the socket member. In this position, the bottom of the electronic device and the bottom of the storing groove are in contact with each other. As is apparent from Figure 2, showing the section of the socket which is capped by the cover, spring contacts achieve electric connection with the leads of the electronic device stored in the storing groove have distal end portions each of which are formed into a semicircular shape.

In the conventional socket having the above structure, an electronic device (e.g., a rectangular one as shown in the drawings) to be stored is often of a small size. It is cumbersome to hold a small electronic device and properly store it in a storing groove by correctly aligning its four sides, and this operation typically results in low operational efficiency.

While the cover is capped, it covers the upper portion of the electronic device to interfere with heat dissipation from the electronic device. As the bottom of the stored electronic device and the bottom of the storing groove are in contact with each other, the heat dissipation effect of the electronic device can be degraded.

Furthermore, when the spring contacts are pushed in, if they are conventional semicircular contacts, they are sometimes dislocated and deformed to an unrestorable degree.

### Summary of the Invention

It is an object of the present invention to eliminate the conventional drawbacks described above.

In order to achieve the above object, according to the present invention, a constricted portion is provided to a socket member, so that means for holding an electronic device to be stored will not collide with the socket member but the electronic device can be easily stored in a storing portion, thereby improving the operational efficiency. A window is formed in a cover so as to entirely expose the top surface of the stored electronic device. A gap is provided between the bottom of the electronic device and the bottom of the socket member, so that heat can be easily dissipated from the electronic device. Furthermore, the contacts of the spring contacts are formed into arcuated shapes, so that the contacts will not be easily deformed.

### Brief Description of the Drawings

Figure 1 is a perspective view showing a cover and a socket member of a socket according to the present invention.

Figure 2 is a sectional view showing the socket which stores an electronic device and which is capped by the cover.

Figure 3 is a plan view showing the socket which stores the electronic device and which is capped by the cover.

Figure 4 is partially sectional side view showing the socket which stores the electronic device and which is capped by the cover.

Figure 5 is a perspective view showing a socket member and a cover of a conventional socket.

Figure 6 is a sectional view showing the conventional socket which stores an electronic device and which is capped by the cover.

Figure 7 is a plan view showing the conventional socket which stores the electronic device and which is capped by the cover.

Figure 8 is a partially sectional side view showing the conventional socket which stores the electronic device and which is capped by the cover.

### Detailed Description of the Preferred Embodiment

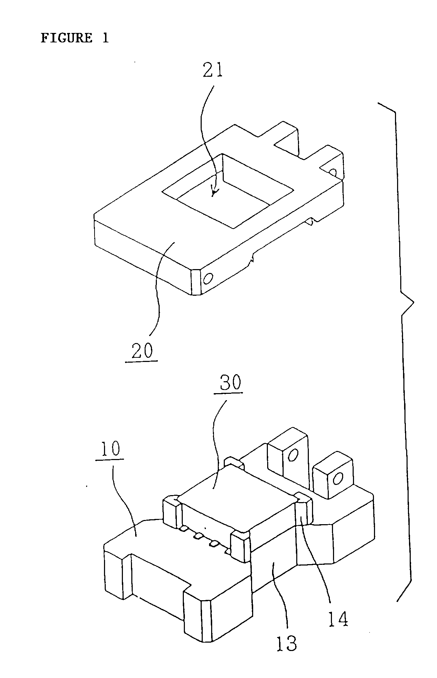

Figures 1 to 4 show a preferred embodiment of the present invention and respectively correspond to Figures 5 to 8, which show a conventional socket member.

A socket for electric device according to the present invention is constituted by a socket member 10 and a cover 20 which can freely cap/uncap the socket member.

As is apparent from Figure 2, in this embodiment, one of the opposing sides (shorter sides in this embodiment) of the cover is axially supported by one of the opposing sides (shorter sides in this embodiment) of the socket member through a coil spring 40. At this position, the coil spring 40 biases the cover in an uncapping direction. A locking segment 41 is axially supported by the other one of the opposing sides of the cover through a coil spring 42. This coil spring biases the locking segment in a capping direction. When the cover is capped, a protrusion 41A formed on the distal end of the locking segment is latched by a locking groove formed in a corresponding portion of the socket member, and this state is maintained by the operation of the coil spring 42. When releasing the latched protrusion, a lever 41B provided to a side of the locking segment opposite to the protrusion is operated to pivot the locking segment. At this stage, the cover is uncapped to rotate about the shorter side axially supporting the coil spring 40 as the axis.

A storing portion 11 for storing an electronic device 30 is formed in the top surface of the socket member. Spring contact elements 12 are provided upright in the socket member so that they support the electronic device and are brought into contact with leads 31 of the electronic device, thereby achieving electric contact.

A constricted portion 13 is formed at a side of the socket member to which the cover is not axially mounted (see Fig.1). The storing portion for the electronic device is formed in this restricted portion. The storing portion is formed to have a width equal to or smaller than that of the electronic device stored in the storing portion, so that the trunk portion of the stored electronic device is partly exposed. As the electronic device of this embodiment does not have leads on a side of the exposed trunk portion, substantially the entire portions of the opposing side surfaces of the trunk portion where leads are not provided are exposed.

The storing portion 11 is constituted by a plurality of guide posts 14 having a shape matching the shape of the electronic device to be stored, and a bottom 15. In the embodiment shown in Figures 1 to 4, post guides each having an L-shaped section are provided to portions on the socket member corresponding to the four corners of the rectangular electronic device. In the embodiment shown in Figures 1 to 4, a recessed groove 17 is formed in the bottom of the storing portion so as to define a gap 16 with the bottom surface of the electronic device stored in the storing portion (see Figure 4). A part or all of the bottom of the storing portion passes through the socket member.

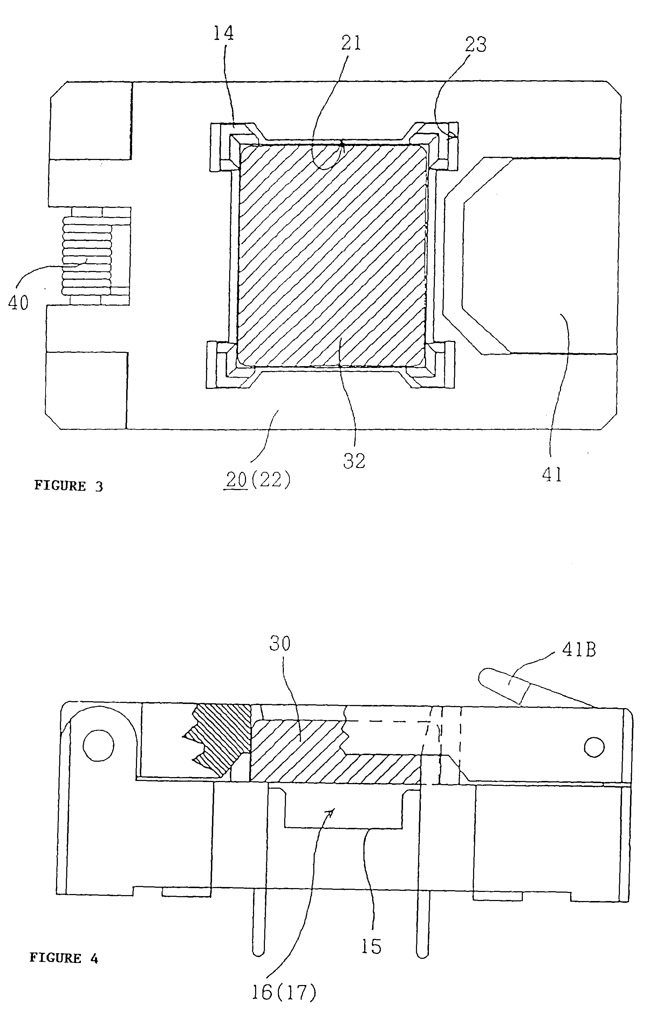

A window 21 is formed in the cover of the socket of the present invention so as to expose a top surface 32 of the electronic device stored in the storing portion when the cover caps the socket member. It is preferable that the top surface of the exposed electronic device and a top surface 22 of the cover be of substantially equal height. Recesses 23 are formed in the four corners of the window (rectangular in this embodiment in accordance with the shape of the electronic device) of the cover in accordance with the shape of the guide posts, so as to accept the guide posts of the storing portion (see Figure 3).

The thickness of the window portion of the cover may be decreased to increase the area of the stored electronic device which is exposed upon capping the cover.

Protrusions 24, each having a knife edge-shaped section, are formed on portions of the cover of the socket of the present invention corresponding to the leads of the electronic device stored in the storing portion, so that they press the leads when the cover is capped. A plurality of protrusions are provided for the respective or arbitrarily selected leads. In the embodiment shown in Figures 1 to 4, these protrusions are formed on each of (a pair of) press segments 25 provided on the opposing surfaces of the inner walls forming the window of the cover (see Figure 2).

As is apparent from Figure 2, each spring contact element 12 provided upright to the socket member consists of a contact 12A, a leg portion 12B, an arcuated connecting portion 12C. The contact 12A is brought into contact with the lead of the electronic device to achieve electric connection therewith. The leg portion 12B extends from the socket member outwardly. The arcuated connecting portion 12C connects the contact 12A and the leg portion 12B. The contact of each spring contact element 12 is formed into an arc. In the embodiment shown in Figure 2, the contact is shaped like a character L, and a portion of the contact corresponding to a low side of the character L is shaped like an arc.

In the socket according to the present invention, a constricted portion is formed in its storing portion that stores an electronic device. Thus, in storing an electronic device in this storing portion, an inconvenience wherein a finger or a mechanical element holding the electronic device is brought into contact or collides with the storing portion is eliminated, thereby remarkably improving the operability.

A part or all of the bottom of the storing portion of the socket according to the present invention is formed to pass through the socket member. An electronic device is stored such that a gap is formed between the bottom of the storing portion and the bottom of the electronic device. A window is formed in the cover so that the top surface of the electronic device stored in the storing portion is exposed through it when the cover caps the socket member. Thus, heat dissipation from the electronic device is more readily achieved.

Since the window formed in the cover of the socket according to the present invention is engaged with the guide posts, the height of the top surface of the cover from the contact can be decreased, thereby obtaining a socket having a low profile.

Since protrusions each having a knife edge-shaped section are formed at portions of the cover corresponding to the leads of the electronic device, floating of the electronic device and deformation of the leads of the electronic device can be prevented.

Since the contacts of the spring contact elements have arcuated shapes, the inconvenience of the dislocation and deformation of the contact upon being pushed in can be eliminated. Since the distance by which the leads of the electronic device slide on the contact portions can be set large, a large cleaning effect can be obtained.

Having described the preferred embodiments herein, it can be appreciated that the scope of the invention is limited only by the claims, appended hereto.

## Claims

1. A socket for an electronic device, comprising:
a socket member (10); and
a cover (20) provided on said socket member in such a manner that said cover can cap/uncap said socket member, there being on said socket member a storing portion (11) for storing an electronic device (30), and in said socket member there are embedded contact elements (12) for supporting said electronic device and making contact with respective leads of said electronic device to achieve electric connection, said socket member comprising a constricted portion (13) so as to externally expose a part of said electronic device stored in said storing portion.

2. A socket according to claim 1, wherein said constricted portion is so formed that a width of said storing portion is substantially equal to or narrower than a width of said electronic device stored in said storing portion.

3. A socket according to claim 1, or claim 2 wherein said storing portion comprises a plurality of guide posts (14) and a bottom (15).

4. A socket according to claim 3, wherein a part of the entirety of the bottom of said storing portion passes through said socket member.

5. A socket according to claim 3 or claim 4, wherein said storing portion stops said electronic device, with a gap made between the bottom thereof and said electronic device.

6. A socket according to any one of claims 1 to 5, wherein said cover comprises a window (21) so as to externally expose a top surface (32) of said electronic device stored in said storing portion when said cover caps said socket member.

7. A socket according to claim 6, wherein the exposed top surface of said electronic device and a top surface (22) of said cover are of substantially equal height.

8. A socket according to claim 6, or claim 7 as dependent on any one of claims 3 to 5 wherein the window of said cover engages the guides.

9. A socket according to any one of claims 1 to 8, wherein on portions of said cover corresponding to the leads of said electronic device there are formed protrusions (24) having a knife edge-shaped section.

10. A socket according to any one of claims 1 to 9, wherein a contact (12A) of said spring contact element has an arc section.

11. A socket according to claim 10, wherein said spring contact element is shaped like a character L, and a section corresponding to the lower side of the character L is shaped like an arc.
